## Europäisches Patentamt
## European Patent Office
## Office européen des brevets

(19)

(11) Veröffentlichungsnummer : **0 170 909**
**B1**

(12)

# EUROPÄISCHE PATENTSCHRIFT

(45) Veröffentlichungstag der Patentschrift :
26.04.89

(51) Int. Cl.⁴ : **F 02 M 51/08, H 01 L 41/04**

(21) Anmeldenummer : **85108498.8**

(22) Anmeldetag : **09.07.85**

(54) **Piezokeramische Ventilplatte für ein Niederdruckeinspritzventil und Verfahren zu deren Herstellung.**

(30) Priorität : **10.07.84 DE 3425290**

(43) Veröffentlichungstag der Anmeldung :
**12.02.86 Patentblatt 86/07**

(45) Bekanntmachung des Hinweises auf die Patenterteilung : **26.04.89 Patentblatt 89/17**

(84) Benannte Vertragsstaaten :
**AT BE CH DE FR GB IT LI NL SE**

(56) Entgegenhaltungen :
**DE-A- 3 313 837**
**US-A- 2 139 469**
**US-A- 3 856 513**
**Römpps Chemie-Lexikon, 7. Auflage, Seiten 88, 89,
1303.**
**Die Akte enthält technische Angaben, die nach dem
Eingang der Anmeldung eingereicht wurden und die
nicht in dieser Patentschrift enthalten sind.**

(73) Patentinhaber : **Atlas Fahrzeugtechnik GmbH
Eggenpfad 26
D-5980 Werdohl (DE)**

(72) Erfinder : **Brandner, Burkhard
Bornstrasse 2
D-5980 Werdohl (DE)**

(74) Vertreter : **Hassler, Werner, Dr.
Postfach 17 04 Asenberg 62
D-5880 Lüdenscheid (DE)**

## Beschreibung

Die Erfindung betrifft eine für ein Niederdruckeinspritzventil als Biegeschwinger ausgebildete piezokeramische Ventilplatte mit einer Trägerplatte und mit einseitig oder beidseitig über eine Bindeschicht gehaltenen, versilberten Piezokeramikplatten.

Bei bekannten Ventilplatten dieser Art besteht die Trägerplatte aus Metall, insbesondere Messing, Stahl oder dergleichen. Die Piezokeramikplatten sind durch eine Bindeschicht aus einem Klebstoff befestigt. Der Klebstoff hat unter anderem die Aufgabe, die sehr unterschiedlichen Ausdehnungskoeffizienten zwischen den metallischen Träger und der Keramikplatte auszugleichen. Die Bindeschicht aus Klebstoff ist jedoch hierzu nur begrenzt in der Lage, wenn der Einsatztemperaturbereich groß ist.

In kraftfahrzeugtechnischen Anwendungen, wenn die Ventilplatte für ein Kraftstoffeinspritzventil eingesetzt wird, reicht der Einsatztemperaturbereich von —30 °C bis + 80 °C.

Aufgabe der Erfindung ist die Bereitstellung eines Biegeschwingers, der innerhalb eines großen Temperaturbereiches eine einwandfreie und dauerhafte Verbindung zwischen der Trägerplatte und der Keramikplatte aufweist.

Diese Aufgabe wird nach der Erfindung dadurch gelöst, daß die Trägerplatte aus einem metallischen Glas besteht und daß die Bindeschicht ein Weichlot mit Sn als Hauptbestandteil und mit einem Legierungsunterdrücker wie Pb, Cd und/oder Ag ist.

Durchgeführte Untersuchungen haben ergeben, daß ein Weichlot mit Sn als Hauptbestandteil für die Bindeschicht sehr geeignet ist. Jedoch war dann das Metall als Werkstoff für die Trägerplatte ungeeignet, weil beim Abkühlen von der Löttemperatur die Piezokeramikplatten zerbrochen wurden.

Die Erfindung unterscheidet sich insofern vom Stand der Technik, als die Trägerplatte aus einem metallischen Glas mit einem sehr geringen Ausdehnungskoeffizienten besteht. Ein metallisches Glas ist z. B. in der US-A-3 856 513 beschrieben. Ein metallisches Glas wird auch als amorphes Metall bezeichnet.

Insbesondere eignet sich eine sogenannte Einschmelzlegierung, die einen besonders kleinen Wärmeausdehnungskoeffizienten hat.

Dass Weichlot stellt eine einwandfreie mechanische und auch elektrische Verbindung zwischen der Trägerplatte und der Piezokeramikplatte her. Der Legierungsunterdrücker verhindert, daß die Versilberung der Piezokeramikplatte aufgelöst und in das Weichlot einlegiert wird.

Besonders geeignet ist nach der Erfindung eine solche Zusammensetzung des Weichlotes, daß das Weichlot als Hauptbestandteil 50 bis 70 % Sn, 0 bis 35 % Pb, 0 bis 25 % Cd, 0 bis 3,5 % Ag, 0 bis 25 % Zn, jeweils in Gewichtsprozent, enthält.

In Weiterbildung betrifft die Erfindung ein Verfahren zur Herstellung einer Ventilplatte der genannten Art, das dadurch gekennzeichnet ist, daß die Anordnung aus Trägerplatte, Weichlot und Piezokeramikplatte bei einer Löttemperatur nahe der Schmelztemperatur des Weichlotes gelötet wird und daß nach der Abkühlung eine Polarisierung der Piezokeramikplatte bei einer Temperatur von 130 °C erfolgt.

Die Löttemperatur wird möglichst niedrig gewählt, um die Piezokeramikplatte möglichst wenig thermisch zu belasten und die Neigung zur Legierungsbildung mit der Versilberung klein zu halten. Im Anschluß an die Lötung erfolgt die polarisierung der Piezokeramikplatte. Die gesamte Anordnung kann ohne weiteres auf die erfoderliche Behandlungstemperatur von 130 °C aufgewärmt werden, ohne daß es zu nachteiligen Einflüssen auf den Zusammenhalt der Anordnung kommt.

Nach der Erfindung wird die Lötung zweckmäßigerweise bei einer Temperatur zwischen 140 und 260 °C durchgeführt.

Eine Ausführungform der Erfindung wird im folgenden unter Bezugnahme auf die anliegenden Zeichnungen erläutert, in denen darstellen :

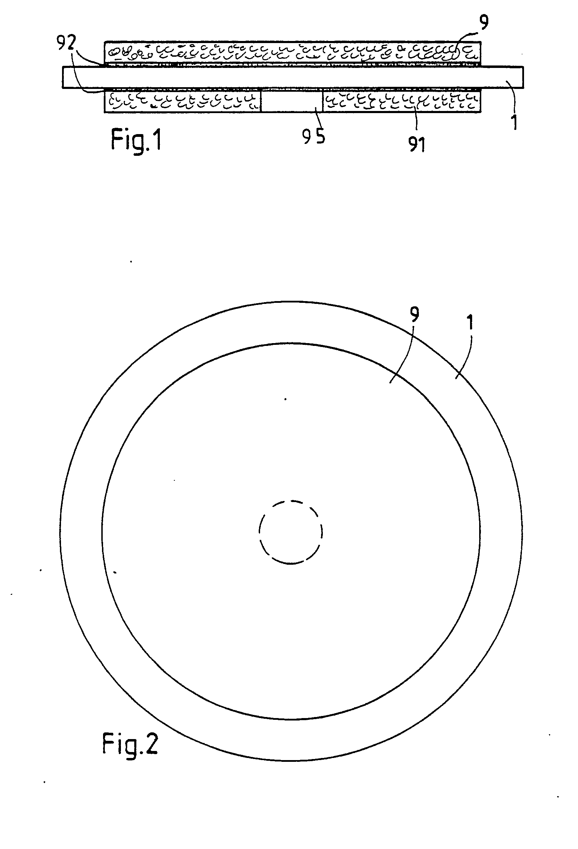

Fig. 1 einen Biegeschwinger nach der Erfindung in der Ansicht,

Fig. 2 eine Draufsicht zu Fig. 1 und

Fig. 3 einen Schnitt durch ein Niederdruckeinspritzventil.

Der Biegeschwinger nach der Erfindung umfaßt eine Trägerplatte 1. Es handelt sich um ein dünnes Blech mit einer Stärke von etwa 0,1 mm. Dieses Blech besteht aus einem metallischen Glas, insbesondere einer Einschmelziegierung.

Auf beiden Seiten dieser Trägerplatte 1 befindet sich je eine Piezokeramikplatte 9, 91, die über eine Bindeschicht 92 mit der Trägerplatte 1 verbunden ist. Die Bindeschicht 92 besteht aus einem Weichlot mit einer niedrigen Schmelztemperatur und einer Zusammensetzung von 50 bis 70 % Sn, 0 bis 35 % Pb, 0 bis 25 % Cd, 0 bis 3,5 % Ag, 0 bis 25 % Zn, jeweils in Gewichtsprozent. Die Legierungsbestandteile Pb, Cd und/oder Ag dienen als Legierungsunterdrücker, um eine Auflösung und Legierungsbildung der Versilberung der Piezokeramikplatten 9, 91 auszuschließen. Jede Piezokeramikplatte 9, 91 ist etwa 0,1 mm dick. Man kann auch nur eine Piezokeramikplatte auf einer Seite der Trägerplatte vorsehen.

Der Durchmesser der Trägerplatte 1 ist etwas größer als der Durchmesser der Piezokeramikplatten 9, 91, damit die Ventilplatte am Rand der Trägerplatte 1 eingespannt werden kann. Eine Piezokeramikplatte 91 kann im Zentrum einen Ausschnitt 95 aufweisen, damit die Trägerplatte 1 mit einem Ventilsitz zusammenwirken kann.

Die Herstellung der Ventilplatte erfolgt in der Weise, daß die Schichten aufeinandergefügt werden und daß eine Lötung bei einer Temperatur zwischen 140 °C und 260 °C erfolgt, wobei diese Löttemperatur möglichst nahe oberhalb der Schmelztemperatur des Lotes gewählt wird. Die Lötzeit selbst soll kurz sein, um eine Legierungsbildung der Silberschicht der Piezokeramikplatten 9, 91 möglichst zu unterdrücken.

Im Anschluß an die Lötung erfolgt eine Polarisierung der Piezokeramikplatten bei einer Temperatur von 130 °C. Die Piezokeramikplatten können in aufgelötetem Zustand polarisiert werden. Die Schichtanordnung aus der Trägerplatte, der Weichlot-Bindeschicht und der Piezokeramikplatte erlaubt diese Temperaturbehandlung. Die Ventilplatte kann innerhalb eines großen Einsatztemperaturbereiches arbeiten. Es ist ohne weiteres ein Einsatztemperaturbereich zwischen — 30 °C und +80 °C zulässig. Infolgedessen kann die Ventilplatte in der Kraftfahrzeugtechnik eingesetzt werden.

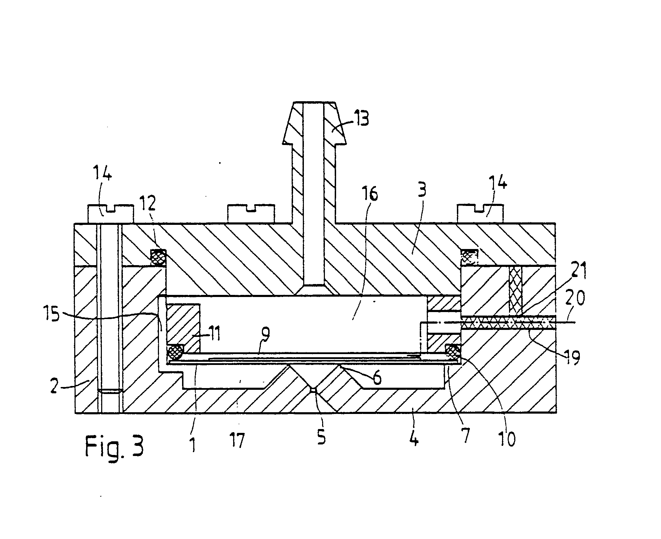

Fig. 3 zeigt ein Niederdruckeinspritzventil mit einer piezokeramischen Ventilplatte. Eine Ventilkammer ist aus einem zylindrischen Gehäuse 2 und einem Gehäusedeckel 3 zusammengesetzt. Das Gehäuse 2 weist in seiner Stirnwand 4 eine zentrale Düse 5 mit einem ringförmigen Ventilsitz 6 auf. In einem Abstand von der Stirnwand 4 ist eine Ringstufe 7 vorgesehen, die zur Auflage der Trägerplatte 1 dient. Ein Dichtring 10 dient zur Einspannung des Randes der Trägerplatte 1. Der Dichtring 10 wird durch einen Spannring 11 gehalten.

Der Gehäusedeckel 3 schließt unter Zwischenlage eines Dichtrings 12 das Gehäuse 2 ab. An dem Gehäusedeckel 3 sitzt ein Stutzen 13 für eine Kraftstoffleitung. Das Gehäuse 2 und der Gehäusedeckel 3 werden durch Schrauben 14 oder andere Verbindungsmittel zusammengehalten.

Der Rand der Trägerplatte 1 liegt auf der Ringstufe 7 auf und dient zur Einspannung. Die Trägerplatte 1 teilt die Ventilkammer in einen Einströmraum 16 und einen Austrittsraum 17. Ein Umgehungskanal 15 verbindet die beiden Räume und stellt einen Druckausgleich zwischen denselben sicher.

Die Piezokeramikplatte 9 ist mit einer Elektrode kontaktiert. Die Trägerplatte 1 dient als Gegenelektrode. Der Spannring 11 sowie die Wandung des Gehäuses 2 besitzen Durchgänge 19 für eine elektrische Anschlußleitung 20, die an die Elektrode der Piezokeramikplatte 9 angeschlossen ist. Die Durchgänge 19 sind mit einer Vergußmasse 21 dicht ausgefüllt.

In Fig. 3 ist eine Ventilplatte mit nur einer Piezokeramikplatte 9 auf einer Seite der Trägerplatte 1 dargestellt. Wenn man eine zweite Piezokeramikplatte vorsieht, so läßt deren zentraler Ausschnitt den Ventilsitz frei, damit die Trägerplatte ummittelbar an dem Ventilsitz anliegt.

Die Funktion des Niederdruckeinspritzventils ergibt sich ohne weiteres aus der vorstehenden Beschreibung und der Zeichnung. An den Stutzen 13 ist eine Kraftstoffdruckleitung angeschlossen, die von einer Druckquelle mit Kraftstoff unter dem Einspritzdruck gespeist wird. Der Kraftstoff füllt die Ventilkammer und insbesondere den Einströmraum 16 sowie den Austrittsraum 17 aus. Die Trägerplatte 1 liegt unter dem Druck des Kraftstoffs an dem Ventilsitz 6 an und dichtet denselben ab. Eine über die Anschlußleitung 20 angelegte Steuerspannung führt zu einer Verformung der Trägerplatte, so daß dieselbe von dem Ventilsitz 6 abhebt und die Düse 5 freigibt. Eine Spannung von etwa 100 V stellt eine Verformung der Trägerplatte 18 im Bereich von 0,15 bis 0,2 mm sicher, so daß dadurch eine ordungsgemäße Funktion des Niederdruckeinspritzventils gewährleistet ist.

**Patentansprüche**

1. Für ein Niederdruckeinspritzventil als Biegeschwinger ausgebildete piezokeramische Ventilplatte mit einer Trägerplatte und mit einseitig oder beidseitig über eine Bindeschicht gehaltenen, versilberten Piezokeramikplatten, dadurch gekennzeichnet, daß die Trägerplatte (1) aus einem metallischen Glas besteht und daß die Bindeschicht (92) ein Weichlot mit Sn als Hauptbestandteil und mit einem Legierungsunterdrücker wie Pb, Cd und/oder Ag ist.

2. Ventilplatte nach Anspruch 1, dadurch gekennzeichnet, daß die Trägerplatte aus einer Einschmelzlegierung besteht.

3. Ventilplatte nach Anspruch 1 oder 2. dadurch gekennzeichnet, daß das Weichlot als Hauptbestandteil 50 bis 70 % Sn, 0 bis 35 % Pb, 0 bis 25 % Cd, 0 bis 3,5 % Ag, 0 bis 25 % Zn, jeweils in Gewichtsprozent, enthält.

4. Ventilplatte nach einem der Ansprüche 1 bis 3, dadurch gekennzeichnet, daß die Piezokeramikplatte (91) einen zentralen Ausschnitt (95) für einen Ventilsitz (6) aufweist.

5. Verfahren zur Herstellung einer Ventilplatte nach einem der Ansprüche 1 bis 4, dadurch gekennzeichnet, daß die Anordnung aus Trägerplatte, Weichlot und Piezokeramikplatte bei einer Löttemperatur nahe der Schmelztemperatur des Weichlotes gelötet wird und daß nach der Abkühlung eine Polarisierung der Piezokeramikplatte bei einer Temperatur von 130 °C erfolgt.

6. Verfahren nach Anspruch 5, dadurch gekennzeichnet, daß die Lötung bei einer Temperatur zwischen 140 und 260 °C erfolgt.

**Claims**

1. Piezoceramic valve plate constructed as a flexural resonator for a low pressure injection valve and having a carrier plate and silvered piezoceramic plates held on one or both sides by a bonding layer, characterised in that the carrier plate (1) comprises a metallic glass, and in that the bonding layer (92) is a soft solder having Sn as its main component and having an alloy suppressor such as Pb, Cd and/or Ag.

2. Valve plate according to Claim 1, characterised in that the carrier plate comprises a fusible alloy.

3. Valve plate according to Claim 1 or 2, characterised in that the soft solder contains as its main component 50 to 70 % of Sn, 0 to 35 % of Pb, 0 to 25 % of Cd, 0 to 3.5 % of Ag, 0 to 25 % of Zn, in each case in percent by weight.

4. Valve plate according to one of Claims 1 to 3, characterised in that the piezoceramic plate (91) has a central cut-out (95) for a valve seat (6).

5. Method for making a valve plate according to one of Claims 1 to 4, characterised in that the arrangement of carrier plate, soft solder and piezoceramic plate is soldered at a soldering temperature close to the melting point of the soft solder, and in that after cooling the piezoceramic plate is polarised at a temperature of 130 °C.

6. Method according to Claim 5, characterised in that the soldering takes place at a temperature between 140 and 260 °C.

**Revendications**

1. Lame de soupape piézocéramique pour une soupape d'injection à basse pression, réalisée sous forme de résonateur de flexions et comprenant une lame de support et des lames piézocéramiques argentées maintenues d'un côté ou des deux côtés par l'intermédiaire d'une couche de liaison, caractérisée en ce que la lame de support (1) est constituée d'un verre métallique et en ce que la couche de liaison (92) est une brasure tendre comportant, comme composant principal, du Sn et un inhibiteur d'alliage tel que Pb, Cd et/ou Ag.

2. Lame de soupape suivant la revendication 1, caractérisée en ce que la lame de support est constituée d'un alliage de fusion.

3. Lame de soupape suivant l'une ou l'autre des revendications 1 et 2, caractérisée en ce que la brasure tendre contient, comme composant principal, de 50 à 70 % de Sn, de 0 à 35 % de Pb, de 0 à 25 % de Cd, de 0 à 3,5 % d'Ag, de 0 à 25 % de Zn, chaque fois en % en poids.

4. Lame de soupape suivant l'une des revendications 1 à 3, caractérisée en ce que la lame piézocéramique (91) présente une découpe centrale (95) pour un siège de soupape (6).

5. Procédé de fabrication d'une lame de soupape suivant l'une des revendications 1 à 4, caractérisé en ce que l'agencement à base de lame de support, brasure tendre et lame piézocéramique est brasé à une température de brasage proche de la température de fusion de la brasure tendre et en ce que, après le refroidissement, une polarisation de la lame piézocéramique a lieu à une température de 130 °C.

6. Procédé suivant la revendication 5, caractérisé en ce que le brasage est effectué à une température comprise entre 140 et 260 °C.

Fig.1

Fig.2

Fig. 3